# EUROPEAN PATENT APPLICATION

(11) **EP 0 528 592 A1**
(43) Date of publication of application: **24.02.1993**
(21) Application number: 92307180.7
(22) Date of filing: 05.08.1992
(51) Int. Cl.: C23C 16/26

(54) **Method for selective CVD diamond deposition**

(30) Priority: 08.08.1991 US 742773
(71) Applicant: GENERAL ELECTRIC COMPANY, Schenectady, NY 12345 (US)
(72) Inventor: Iacovangelo, Charles Dominic, Schenectady, New York 12309 (US)
(74) Representative: Pratt, Richard Wilson

(57) **Abstract**

A method for the selective deposition of chemical vapor deposition (CVD) diamond on a surface of a substrate comprises the steps of masking an area of said surface with a coating material that prevents CVD diamond formation and subjecting the substrate to a CVD diamond deposition process for coating a layer of CVD diamond on the substrate in the unmasked areas only.
Advantageously, the surface first is coated with a layer of material that promotes CVD diamond formation and then the coated substrate is subjected to the masking step. Advantageously, the substrate comprises a twist drill wherein the surfaces perpendicular to the main shear planes involved in drilling, such as the planes forming the cutting edge of the drill, are coated with CVD diamond while the remaining areas of the twist drill remain uncoated.

## Description

The present invention relates to diamond coated workpieces and more particularly to an improved CVD diamond coated twist drill.

Its hardness and thermal properties are but two of the characteristics that make diamond useful in a variety of industrial components. Initially, natural diamond was used in a variety of abrasive applications. With the ability to synthesize diamond by high pressure/high temperature (HP/HT) techniques utilizing a catalyst/sintering aid under conditions where diamond is the thermally stable carbon phase, a variety of additional products found favor in the marketplace. Polycrystalline diamond compacts, often supported on a tungsten carbide support in cylindrical or annular form, extended the product line for diamond additionally. However, the requirement of high pressure and high temperature has been a limitation in product configuration, for example.

Recently, industrial effort directed toward the growth of diamond at low pressures, where it is metastable, has increased dramatically. Although the ability to produce diamond by low-pressure synthesis techniques has been known for decades, drawbacks including extremely low growth rates prevented wide commercial acceptance. Recent developments have led to higher growth rates, thus spurring recent industrial interest in the field. Additionally, the discovery of an entirely new class of solids, known as "diamondlike" carbons and hydrocarbons, is an outgrowth of such recent work.

Low pressure growth of diamond has been dubbed "chemical vapor deposition" or "CVD" in the field. Two predominant CVD techniques have found favor in the literature. One of these techniques involves the use of a dilute mixture of hydrocarbon gas (typically methane) and hydrogen wherein the hydrocarbon content usually is varied from about 0.1 % to 2.5% of the total volumetric flow. The gas is introduced via a quartz tube located just above a hot tungsten filament which is electrically heated to a temperature ranging from between about 1750° to 2400°C. The gas mixture disassociates at the filament surface and diamonds are condensed onto a heated substrate placed just below the hot tungsten filament. The substrate is held in a resistance heated boat (often molybdenum) and heated to a temperature in the region of about 500° to 1100°C, or the substrate can be heated by the filament.

The second technique involves the imposition of a plasma discharge of the foregoing filament process. The plasma discharge serves to increase the nucleation density, growth rate, and it is believed to enhance formation of diamond films as opposed to discrete diamond particles. Of the plasma systems that have been utilized in this area, there are three basic systems. One is a microwave plasma system, the second is an RF (inductively or capacitively coupled) plasma system, and the third is a d.c. plasma system. The RF and microwave plasma systems utilize relatively complex and expensive equipment which usually requires complex tuning or matching networks to electrically couple electrical energy to the generated plasma. Additionally, the diamond growth rate offered by these two systems can be quite modest.

Heretofore, CVD diamond has been coated onto tungsten carbide or other substrates to make cutting tool inserts (U.S. Pat. Nos. 4,707,384 and 4,731,296) or co-deposited with boron or another element for making semiconductors (*e.g.* EP Publications Nos. 286,306 and 282,054). Commonly-assigned application Serial No. 563,367, filed August 7, 1990, discloses a CVD reactor especially adapted to coat twist drills with a layer of CVD diamond, such as the CVD diamond coated twist drill in commonly-assigned U.S. Pat. No. 5,022,801.

Broadly, the present invention is directed to a method for the selective deposition of chemical vapor deposition (CVD) diamond on a surface of a substrate. The method comprises the steps of masking an area of said surface not to be coated with CVD diamond with a coating material that prevents CVD diamond formation. The substrate then is subjected to a CVD diamond deposition process for coating a layer of CVD diamond on the substrate in the unmasked areas only. Advantageously, the surface first is coated with a layer of material that promotes CVD diamond formation and then the coated substrate is subjected to the masking step of the method. Advantageously, the substrate comprises a twist drill wherein the surfaces perpendicular to the main shear planes involved in drilling, such as the planes forming the cutting edge of the drill, are coated with CVD diamond while the remaining areas of the twist drill remain uncoated.

Advantages of the present invention include the ability to selectively deposit CVD diamond. Another advantage is the ability to control patterns of CVD diamond layers applied to substrate. Another advantage is the ability to promote the formation of chemical vapor deposition diamond by coating such areas with a material that promotes CVD diamond formation. These and other advantages will be readily apparent to those skilled in the art based upon the disclosure contained herein.

Twist drills are used extensively in the industrial world. The hardest and longest lasting twist drills are manufactured of tungsten carbide. Even tungsten carbide twist drills, however, suffer premature failure when drilling some composite materials. One means for making such twist drills even harder is to deposit a coating of CVD diamond thereon. The performance of CVD diamond-coated twist drills does not depend on retaining the diamond film over most of the areas of the drill since many areas of the twist drill do not present a cutting edge and, therefore, are not directly involved in cutting performance. Rather, twist drill performance can be improved if the CVD diamond layer is retained on the cutting edge of the drill. Experience has revealed that CVD diamond is retained on surfaces perpendicular to the main shear planes involved in drilling, such as the plane forming the cutting edge of the drill. It would be an advantage, therefore, to control the areas of the twist drill to be coated with CVD diamond while leaving the remaining surfaces not involved in the cutting action uncoated.

Advantageously, the twist drill or other substrate to be coated with CVD diamond is first coated with a material that promotes CVD diamond deposition and adhesion. Such materials include, for example, titanium, chronium, niobium, molybdenum, tungsten, and the like, and mixtures and alloys thereof. Such materials can be coated onto the twist drill or other substrate by a variety of techniques including, for example, electroless plating and electroplating, chemical vapor deposition techniques, plasma flame techniques, and a variety of additional techniques well known in the art.

In the next step of the method, the areas of the substrate which do not need to be coated with diamond then are selectively coated with a second coating that promotes sooting rather than diamond deposition during the CVD process. This coating can be made from materials including, for example, cobalt, nickel, iron, and the like, and mixtures and alloys thereof. Again, in order to form the second coating pattern, the twist drill or other substrate can be first masked with a material that prevents the cobalt or other material from adhering to the substrate. Numerous maskants in the electroplating and electroless plating art are available and include, for example, the AZ® 4000 series of photoresists sold by Hoechst AG, Somerville, N.J.

With respect to conventional CVD processes useful in the present invention, hydrocarbon/hydrogen gaseous mixtures are fed into a CVD reactor as an initial step. Hydrocarbon sources can include the methane series gases, *e.g.* methane, ethane, propane; unsaturated hydrocarbons, *e.g.* ethylene, acetylene, cyclohexene, and benzene; and the like. Methane, however, is preferred. The molar ratio of hydrocarbon to hydrogen broadly ranges from about 1:10 to about 1:1,000 with about 1:100 being preferred. This gaseous mixture optionally may be diluted with an inert gas, *e.g.* argon. The gaseous mixture is at least partially decomposed thermally by one of several techniques known in the art. One of these techniques involves the use of a hot filament which normally is formed of tungsten, molybdenum, tantalum, or alloys thereof. U.S. Pat. No. 4,707,384 illustrates this process.

The gaseous mixture partial decomposition also can be conducted with the assistance of d.c. discharge or radio frequency electromagnetic radiation to generate a plasma, such as proposed in U.S. Pats. Nos. 4,749,587, 4,767,608, and 4,830,702; and U.S. Pat. No. 4,434,188 with respect to use of microwaves. The substrate may be bombarded with electrons during the CVD decomposition process in accordance with U.S. Pat. No. 4,740,263.

Regardless of the particular method used in generating the partially decomposed gaseous mixture, the substrate is maintained at an elevated CVD diamond-forming temperature which typically ranges from about 500° to 1100° C and preferably in the range of about 850° to 950° C where diamond growth is at its highest rate in order to minimize grain size. Pressures in the range of from about 0.01 to 1000 Torr, advantageously about 100-800 Torr, are taught in the art, with reduced pressure being preferred. Details on CVD processes additionally can be reviewed by reference to Angus, *et al.*, "Low-Pressure, Metastable Growth of Diamond and 'Diamondlike' Phases", *Science*, vol. 241, pages 913-921 (August 19, 1988); and Bachmann, *et al.*, "Diamond Thin Films", *Chemical and Engineering News*, pages 24-39 (May 15, 1989). The disclosures of all citations herein are expressly incorporated herein by reference.

## Claims

1. A method for the selective deposition of chemical vapor deposition (CVD) diamond on a surface of a substrate, which comprises the steps of :
(a) masking an area of said surface not to be coated with CVD diamond with a coating of material that prevents CVD diamond formation;
(b) subjecting said substrate to a CVD diamond deposition process for coating a layer of CVD diamond on said substrate in the unmasked area only.

2. The method of Claim 1 wherein said surface in step (a) is masked with one or more of Co, Ni, and Fe.

3. The method of Claim 1 or Claim 2 wherein said surface is first coated with a layer of material that promotes CVD diamond formation and then said coated substrate is subjected to step (a) of the method.

4. The method of Claim 3 wherein said surface is first coated with a layer of material which is one or more of Ti, Cr, Nb,, Mo, and W.

5. The method of Claim 3 or Claim 4 wherein said first coated surface is covered with a maskant for the area to be coated with a layer of CVD diamond, said coated surface then is subjected to step (a), the maskant then is removed, and the coated surface is subjected to step (b).

6. The method of any preceding claim wherein said substrate comprises a twist drill.

7. The method of Claim 6 wherein said twist drill is formed from tungsten carbide.

8. The method of Claim 6 wherein said twist drill is formed from metal.
